# FASCICULE DE BREVET EUROPEEN

(11) **EP 2 084 759 B1**
(45) Date de publication et mention de la délivrance du brevet: **19.06.2019**
(21) Numéro de dépôt: 07822758.4
(22) Date de dépôt: 20.11.2007
(51) Int. Cl.: H01L 51/52, H01L 27/32

(54) **DISPOSITIF EMISSIF LUMINEUX DE TYPE OLED**
LICHTEMITTIERENDES BAUELEMENT DES OLED-TYPS
LIGHT-EMITTING DEVICE OF THE OLED TYPE

(30) Priorité: 24.11.2006 FR 0610291
(43) Date de publication de la demande: 05.08.2009
(73) Titulaire: Commissariat à l'Énergie Atomique et aux Énergies Alternatives, 75015 Paris (FR)
(72) Inventeur: DESIERES, Yohan, 38250 LANS EN VERCORS (FR); GIDON, Pierre, 38130 Echirolles (FR); POUPINET, Ludovic, 38360 Sassenage (FR); MOUREY, Bruno, 38500 Coublevie (FR)
(74) Mandataire: Ilgart, Jean-Christophe
(86) Numéro de dépôt international: PCT/EP2007/062587
(87) Numéro de publication internationale: WO 2008/061988

(56) Documents cités:
- US-A1- 2001 038 102
- US-A1- 2004 206 965
- LEE YONG-JAE ET AL: "A high-extraction-efficiency nanopatterned organic light-emitting diode" APPLIED PHYSICS LETTERS, AIP, AMERICAN INSTITUTE OF PHYSICS, MELVILLE, NY, US, vol. 82, no. 21, 26 mai 2003 (2003-05-26), pages 3779-3781, XP012034228 ISSN: 0003-6951
- HOEFLER T ET AL: "MODIFYING THE OUTPUT CHARACTERISTICS OF AN ORGANIC LIGHT-EMITTING DEVICE BY REFRACTIVE-INDEX MODULATION" ADVANCED FUNCTIONAL MATERIALS, WILEY VCH, WIENHEIM, DE, vol. 16, no. 18, 3 novembre 2006 (2006-11-03), pages 2369-2373, XP001504252 ISSN: 1616-301X
- HAO X T ET AL: "Colour tunability of polymeric light-emitting diodes with top emission architecture" SEMICONDUCTOR SCIENCE AND TECHNOLOGY, IOP, BRISTOL, GB, vol. 21, no. 1, 1 janvier 2006 (2006-01-01), pages 19-24, XP020098198 ISSN: 0268-1242 cité dans la demande

## Description

### DOMAINE TECHNIQUE ET ART ANTÉRIEUR

L'invention concerne une électrode structurée d'un dispositif émissif lumineux de type OLED (« Organic Light Emitting Diode » en anglais, ou diode électroluminescente organique) et un dispositif OLED comportant une telle électrode. L'invention sera particulièrement adaptée à la réalisation d'un dispositif émettant de la lumière sur plusieurs longueurs d'ondes, c'est-à-dire un dispositif d'affichage multicolore, à base de couches organiques électroluminescentes utilisé dans un afficheur ou un écran de type OLED, et notamment dans un micro-afficheur de type OLED de dimensions centimétriques.

Ces micro-afficheurs sont de petits écrans facilement transportables et dont la visualisation peut se faire à l'aide d'une optique d'agrandissement. Ces dispositifs sont particulièrement adaptés pour la réalisation d'optiques de visée, par exemple pour des appareils photos ou caméscopes numériques. Ces micro-afficheurs sont également adaptés pour un fonctionnement dans des lunettes de visualisation connectées par exemple à un lecteur vidéo nomade. Un micro-afficheur doit être peu cher et avoir une faible consommation électrique.

Un micro-afficheur classique de type OLED comporte un empilement de couches organiques électroluminescentes émettant une lumière de couleur blanche. Cet empilement est disposé entre une matrice d'anodes et une cathode commune à tout le micro-afficheur. L'émission lumineuse est réalisée à travers la cathode, qui est transparente. Les couches organiques sont déposées de manière homogène sur la matrice d'anodes. Du côté opposé à l'empilement de couches organiques, la matrice d'anodes est également en contact avec une matrice active de transistors, ou matrice TFT (« Thin-Film Transistor » en anglais, ou transistor à couches minces). Chaque transistor permet de piloter individuellement l'émission de lumière depuis chaque anode, représentant un pixel du micro-afficheur, en faisant circuler un courant entre l'anode et la cathode à travers les couches organiques. Pour réaliser des pixels de différentes couleurs (rouge, vert et bleu par exemple), une matrice de filtres à base de polymères pigmentés est réalisée sur un substrat hôte transparent puis reportée sur la cathode de manière homogène. Cette matrice de filtres est réalisée sur le substrat hôte par photolithographie de polymères pigmentés photosensibles.

Un tel micro-afficheur de type OLED a une faible consommation électrique. Mais compte tenu des dimensions des pixels de ces écrans (quelques microns), les dimensions de marges d'alignement prises pour l'étape de report de la matrice de filtres sur la cathode sont équivalentes aux dimensions des pixels eux-mêmes, réduisant la surface utile et augmentant notablement le coût du micro-afficheur.

Une telle matrice de filtres peut également être réalisée par photolithographie directement sur la cathode. Mais dans ce cas également, un alignement durant les étapes de photolithographie sur les anodes et les transistors de la matrice active situés sous les couches organiques est nécessaire, complexifiant la réalisation de cette matrice de filtres. De plus, cette solution est particulièrement agressive pour les couches organiques qui peuvent se détériorer.

Ces électrodes, c'est-à-dire les anodes et la cathode, lorsqu'elles sont suffisamment réfléchissantes, forment des cavités optiques qui filtrent la lumière blanche émise par les couches organiques, cette lumière filtrée étant ensuite émise à travers la cathode qui forme un miroir semi-transparent. On entend par cavité optique, ici et dans tout le reste du document, un espace géométrique limité par au moins deux surfaces au moins partiellement réfléchissantes dont l'alignement permet à des rayons lumineux d'y subir de multiples réflexions. La couleur émise par le pixel à travers la cathode dépend alors de l'épaisseur des couches organiques et de l'indice de réfraction optique de ces couches organiques. Ce type de structure ne nécessite donc pas de matrice de filtres à base de polymères pigmentés. Les documents « Organic Light Emitting Devices » de J. Shinar, 2003, page 103, et « Colour tunability of polymeric light-emitting diodes with top emission architecture » de X.T. Hao et al., Semiconductor Science and Technology, vol. 21, n°1, janvier 2006, pages 19 à 24, décrivent de telles structures mises en oeuvre dans des diodes électroluminescentes organiques et inorganiques, améliorant la directivité, le rendement optique, et déterminant la couleur émise par les pixels.

Toutefois, la réalisation d'un tel empilement de couches, permettant d'accorder les cavités optiques sur différentes couleurs d'un pixel à l'autre, en conservant le même empilement de couches organiques pour tous les pixels et en modulant l'épaisseur de ces couches d'un pixel à l'autre, est complexe.

Dans le document US 7,023,013 B2, la réalisation de pixels de couleurs différentes n'est pas obtenue en modulant l'épaisseur des couches organiques, mais en intégrant des plots d'ITO (« Indium-Tin Oxide » en anglais, ou oxyde d'indium-étain) de hauteurs variables entre les couches organiques et les anodes. Une telle structure nécessite de nombreuses étapes de photolithogravure pour définir sur chaque pixel une couche d'ITO d'une épaisseur correspondant à la couleur désirée. Cette approche reste donc coûteuse, notamment pour la réalisation de micro-afficheurs.

Le document US 2001/038102 A1 décrit un dispositif émissif lumineux de type OLED comportant une cavité optique résonante formée par une partie d'une couche à base d'un matériau organique électroluminescent disposée entre deux électrodes totalement réfléchissantes.

Le document US 2004/0206965 A1 décrit un dispositif émissif lumineux de type OLED avec une structure de couplage pour augmenter l'extraction de la lumière.

### EXPOSÉ DE L'INVENTION

Un but de la présente invention est de proposer une solution permettant la réalisation d'un dispositif émissif lumineux de type OLED pouvant émettre de la lumière sur différentes longueurs d'onde d'un pixel à l'autre, sans complexifier la réalisation d'un tel dispositif, et à un coût inférieur aux procédés de l'art antérieur.

Pour cela, il est proposé une électrode de dispositif émissif lumineux de type OLED adaptée pour former, avec une seconde électrode, une cavité optique, comportant au moins une couche à base d'un matériau d'indice de réfraction n₁ dont une face structurée, par exemple destinée à être disposée du côté de la cavité optique, comprend une pluralité de creux remplis d'un matériau d'indice de réfraction n₂ différent de n₁.

Ainsi, on réalise une modulation planaire, c'est-à-dire dans le plan de la couche formant l'électrode, sans faire varier la hauteur de cette couche, de l'indice de réfraction optique effectif de l'électrode d'une cavité optique. Il est donc possible de modifier cet indice de réfraction effectif en jouant sur les indices de réfraction n₁ et n₂ des matériaux utilisés et/ou en modifiant la forme et les dimensions des creux, et ainsi d'obtenir une cavité optique dont la fréquence de résonance peut être accordée sur une quelconque longueur d'onde, permettant par exemple de choisir la couleur de la lumière émise par la cavité optique, sans complexifier, ni augmenter le coût de réalisation du dispositif émissif lumineux.

L'électrode structurée peut permettre également de modifier la direction de propagation de l'émission lumineuse du dispositif en sélectionnant les modes émis, optimisant ainsi le gain optique du dispositif émissif lumineux. Lorsque les creux de la face structurée sont régulièrement répartis selon un motif de répétition de période proche de la longueur d'onde d'émission souhaitée de la cavité optique, ou plus généralement une période comprise entre environ la moitié de cette longueur d'onde et environ 1,5 fois cette longueur d'onde, l'invention permet alors de supprimer les modes guidés émis dans le plan des couches organiques du dispositif ou de permettre à ces modes guidés de rayonner hors du dispositif selon des angles spécifiques à la géométrie de structuration. Cette dernière solution permet notamment de concentrer l'émission lumineuse dans un cône dont l'axe centrale est sensiblement perpendiculaire aux plans des couches organiques. On réduit ainsi le nombre de photons pouvant être piégés dans les couches organiques en favorisant une émission lumineuse hors du composant.

Le motif (forme, dimensions, période de répétition, ...) des creux réalisés au niveau de la face structurée peut donc être choisi en fonction du spectre d'émission souhaité de la cavité optique, mais également de la directivité d'émission souhaitée.

Les creux peuvent être répartis régulièrement sur la face structurée et/ou être de dimensions sensiblement similaires, permettant de définir précisément la longueur d'onde de la lumière émise en sortie de la cavité optique.

Le matériau d'indice de réfraction n₁ et/ou le matériau d'indice de réfraction n₂ peuvent être électriquement conducteurs, par exemple à base de métal.

L'électrode peut également comporter au moins une couche inférieure à base d'au moins un matériau électriquement conducteur, par exemple à base de métal, sur laquelle est disposée la couche d'indice de réfraction n₁. Le matériau d'indice de réfraction n₁ peut dans ce cas être par exemple un matériau diélectrique. Il est donc possible de choisir un matériau dont l'indice de réfraction n₁ peut ne pas exister pour un matériau électriquement conducteur. Cette configuration permet également de profiter de gravure sélective.

Dans ce cas, lorsque le matériau d'indice de réfraction n₁ et/ou le matériau d'indice de réfraction n₂ est électriquement conducteur, on maintient un lien de conduction électrique entre la couche inférieure et la face structurée comportant les creux.

Ce lien de conduction électrique entre la couche inférieure et la face structurée comportant les creux peut également être obtenu par une portion de matériau électriquement conducteur reliant la couche inférieure à la face structurée, par exemple lorsque ni le matériau d'indice de réfraction n₁, ni le matériau d'indice de réfraction n₂, est électriquement conducteur. Ainsi, aucune contrainte de conduction électrique ne s'applique à l'un des matériaux d'indice de réfraction n₁ ou n₂. Cette portion de matériau électriquement conducteur peut traverser la couche d'indice de réfraction n₁ et éventuellement le matériau d'indice de réfraction n₂.

L'électrode peut comporter en outre une couche supérieure à base d'au moins un matériau électriquement conducteur, disposée contre la face structurée de la couche d'indice de réfraction n₁, ou sur la couche d'indice de réfraction n₁. Cette couche supérieure peut être optiquement transparente ou partiellement transparente, et par exemple à base d'ITO. Cette couche peut également être une très fine couche métallique, par exemple à base de TiN et d'épaisseur inférieure ou égale à environ 10 nm, ou comprise entre environ 2 nm et 20 nm. Cette couche supérieure permet d'homogénéiser la circulation du courant électrique entre les électrodes, à travers les couches organiques.

Le matériau d'indice de réfraction n₁ et le matériau d'indice de réfraction n₂ peuvent être des diélectriques.

Dans ce cas, l'électrode peut comporter en outre, lorsque l'électrode comporte la couche inférieure et la couche supérieure, au moins une portion de matériau électriquement conducteur reliant électriquement la couche inférieure à la couche supérieure.

Le matériau d'indice de réfraction n₂ et/ou le matériau d'indice de réfraction n₁ peuvent être transparents ou partiellement transparents.

Les creux peuvent traverser la couche d'indice de réfraction n₁.

La présente invention concerne également un dispositif émissif lumineux de type OLED comportant l'ensemble des caractéristiques de la revendication 1.

De manière avantageuse, les creux de la face structurée de l'électrode peuvent être disposés du côté de la cavité optique.

Ce dispositif permet d'obtenir une émission lumineuse spécifique en sortie de la cavité optique grâce à l'électrode structurée. On peut donc définir, grâce à l'électrode structurée, la couleur émise par le pixel formé par la cavité optique, ainsi que la direction de l'émission, en réalisant une structuration spécifique de cette électrode, soit par les dimensions et formes des creux réalisés et/ou soit par leur arrangement sur la face structurée de l'électrode et/ou le choix des indices de réfraction n₁ et n₂.

Le matériau d'indice de réfraction n₂ remplissant les creux de la face structurée de l'électrode peut être le matériau organique électroluminescent de la couche disposée entre les deux électrodes.

Dans une variante, le matériau d'indice de réfraction n₂ remplissant les creux de la face structurée de l'électrode peut être un matériau distinct du matériau organique électroluminescent de la couche disposée entre les deux électrodes.

Le dispositif émissif lumineux peut comporter en outre un substrat contre lequel est disposée une des électrodes de la cavité optique, cette électrode pouvant par exemple former une anode du pixel défini par cette cavité optique. Cette électrode peut notamment être une électrode structurée, objet de la présente invention, telle que décrite précédemment.

Le dispositif émissif lumineux peut comporter en outre une pluralité de cavités optiques comprenant une électrode structurée telle que décrite précédemment, formant une pluralité de pixels du dispositif émissif lumineux de type OLED.

Dans ce cas, une des électrodes, par exemple l'électrode structurée, de chaque cavité optique peut être disposée contre le substrat, formant par exemple une anode d'un pixel du dispositif émissif lumineux.

Les dimensions et/ou la période des creux des électrodes structurées peuvent donc différer d'un pixel à l'autre, afin d'obtenir des pixels de différentes couleurs. On peut ainsi facilement réaliser, par le biais d'une seule photolithogravure, un écran couleur.

Les électrodes des différents pixels peuvent être électriquement isolées les unes des autres.

Les électrodes de chaque cavité optique qui ne sont pas disposées contre le substrat peuvent être formées par une seule électrode commune à toutes les cavités optiques, cette électrode commune étant par exemple la cathode des pixels du dispositif émissif lumineux.

Le substrat peut comporter au moins un circuit d'adressage relié électriquement aux électrodes disposées contre le substrat et pilotant les pixels du dispositif. Le circuit d'adressage peut comporter une matrice de transistors, chacun des pixels pouvant être piloté par un transistor de cette matrice par l'intermédiaire des électrodes disposées contre le substrat. Il est particulièrement avantageux que l'électrode structurée soit l'électrode qui est en contact avec la matrice active de transistors. On peut ainsi réaliser des éléments de filtrage, c'est-à-dire les électrodes structurées, objets de la présente invention, avant un dépôt des couches organiques sur ces électrodes, et profiter ainsi de moyens d'alignement sub-microniques des technologiques microélectroniques. Ceci permet notamment de réduire les marges d'alignement nécessaires et donc de diminuer le coût surfacique du dispositif.

Une telle électrode permet d'éviter des dépôts de couches organiques électroluminescentes sur des électrodes de hauteurs différentes et d'éviter de multiples étapes de photolithogravure pour spécifier la couleur de chaque pixel. Dans l'invention, une seule étape de photolithogravure permet en effet d'aboutir à des modulations d'indice différent sur chaque pixel d'une matrice comportant plusieurs électrodes structurées, objets de la présente invention.

Le dispositif peut comporter en outre, lorsque le matériau d'indice de réfraction n₁ et le matériau d'indice de réfraction n₂ sont des diélectriques, une portion de matériau conducteur reliant électriquement le circuit d'adressage aux électrodes.

La présente invention concerne également un procédé de réalisation d'un dispositif émissif lumineux de type OLED, comportant l'ensemble des caractéristiques de la revendication 26.

Le procédé peut comporter en outre, après l'étape c), une étape de réalisation d'une portion de matériau électriquement conducteur reliant la couche inférieure à la face comportant la pluralité de creux.

Le procédé peut comporter en outre, après l'étape c), une étape de dépôt d'une couche supérieure à base d'un matériau électriquement conducteur sur la couche de matériau d'indice de réfraction n₁.

L'étape c) peut être une étape de dépôt d'au moins une couche organique électroluminescente sur la face de la couche de matériau d'indice de réfraction n₁ comportant les creux, cette couche organique électroluminescente étant à base du matériau d'indice de réfraction n₂.

Dans une variante, le procédé peut comporter, après l'étape c), une étape de dépôt d'au moins une couche organique électroluminescente sur la couche de matériau d'indice de réfraction n₁.

Le procédé peut comporter, après l'étape de dépôt de la couche organique électroluminescente, une étape de réalisation d'une couche à base d'un matériau électriquement conducteur et au moins semi-transparent sur la couche organique électroluminescente.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1A représente un dispositif émissif lumineux de type OLED, objet de la présente invention, selon un premier mode de réalisation,
- la figure 1B représente un dispositif émissif lumineux de type OLED, objet de la présente invention, selon une variante du premier mode de réalisation,
- les figures 2A et 2B représentent des exemples de réalisation d'une électrode de dispositif émissif lumineux de type OLED, également objet de la présente invention,
- la figure 3 représente des résultats de simulation d'émission lumineuse par un dispositif émissif lumineux de type OLED, objet de la présente invention,
- la figure 4 représente un dispositif émissif lumineux de type OLED, objet de la présente invention, selon un second mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

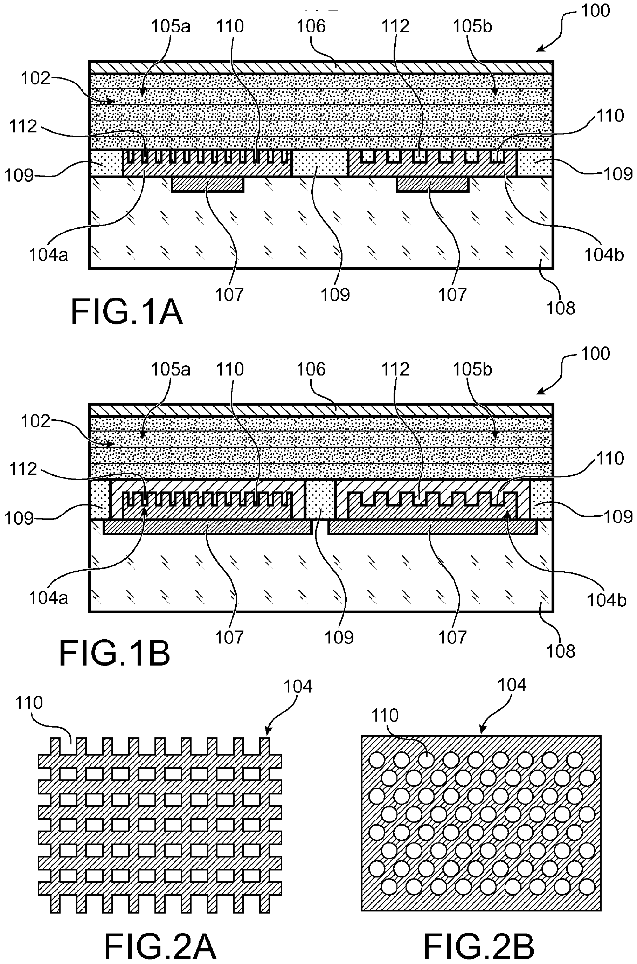

On se réfère tout d'abord à la figure 1A qui représente un dispositif émissif lumineux de type OLED 100 selon un premier mode de réalisation.

Le dispositif 100 comporte un empilement de couches organiques électroluminescentes 102, disposé entre une matrice d'électrodes, ici des anodes, et une électrode 106, ici une cathode, commune à tout le dispositif 100. Sur la figure 1A, seules deux anodes 104a, 104b, sont représentées. Le dispositif 100 comporte également un substrat 108, par exemple à base de silicium, comprenant un circuit d'adressage formé dans ce premier mode de réalisation par une matrice active de transistors 107, ou matrice TFT, en contact avec la matrice d'anodes 104a, 104b. Dans une variante, ce circuit d'adressage peut également être réalisé par des circuits intégrés. Chaque transistor 107 permet de piloter individuellement l'émission de lumière de chaque pixel du dispositif 100 formé par une des anodes 104a, 104b et une portion de la cathode 106 et de l'empilement de couches organiques 102 se trouvant au niveau de l'anode en faisant circuler un courant entre l'anode et la cathode 106 à travers les couches organiques 102. Dans ce premier mode de réalisation, la lumière est émise du dispositif 100 depuis la cathode 106.

Cette cathode 106 est partiellement réfléchissante. Par exemple, la cathode 106 peut avoir un taux de réflexion compris entre environ quelques % et quelques dizaines de %, par exemple égal à environ 10 %. Les anodes 104a, 104b sont réfléchissantes, par exemple avec un taux de réflexion supérieur à environ 50 %, avantageusement supérieur à 80 %, voir supérieur à 90 %, et ainsi, chacune des anodes 104a, 104b forme, avec une portion de l'empilement des couches organiques électroluminescentes 102 et de la cathode 106 se trouvant au-dessus de l'anode 104a, 104b, une cavité optique correspondant à un pixel du dispositif 100. Sur la figure 1A, deux cavités optiques 105a et 105b, formées par l'empilement de couches organiques 102, la cathode 106 et les anodes 104a et 104b sont représentées. Dans ce premier mode de réalisation, les anodes 104a, 104b et la cathode 106 sont réalisées à base d'un matériau métallique, par exemple à base d'aluminium, et/ou d'argent, et/ou d'or, et/ou de chrome, et/ou de titane et/ou d'un alliage réalisé à partir de ces métaux.

Des motifs formant des creux 110 sont gravés dans les anodes 104a, 104b, au niveau d'une face des anodes 104a, 104b se trouvant du côté des cavités optiques 105a, 105b. Ces creux 110 sont remplis avec un matériau 112 d'indice de réfraction n₂ différent de l'indice de réfraction n₁ du matériau formant les anodes 104a, 104b. Ce matériau 112 peut être un matériau diélectrique ou électriquement conducteur, transparent ou semi transparent, tel que par exemple à base de résines photo-polymérisables, et/ou de polymère comme le polyethilènedioxythiophene (PEDOT), et/ou d'ITO, et/ou d'oxyde de silicium, et/ou de nitrure de silicium et/ou encore d'oxyde d'aluminium.

Dans une variante de ce premier mode de réalisation, lorsque les anodes 104a, 104b sont réalisées à base d'un matériau transparent ou semi-transparent, les creux 110 peuvent être gravés à travers la face des anodes 104a, 104b se trouvant en contact avec le substrat 108. Les creux 110 sont dans ce cas également remplis avec le matériau 112 d'indice de réfraction n₂. Les faces des anodes 104a, 104b se trouvant du côté des cavités optiques 105a, 105b peuvent alors être planes. Dans une autre variante, les creux 110 peuvent être réalisés de manière traversante, c'est-à-dire formant des trous traversant les anodes 104a, 104b sur toute leur épaisseur.

Les figures 2A et 2B représentent deux exemples de creux 110 réalisés dans une électrode 104. Sur la figure 2A, les creux 110 réalisés ont une section rectangulaire, alors que les creux 110 représentées sur la figure 2B ont une section circulaire. Les creux 110 peuvent également être réalisés selon un motif différent de ceux représentés sur les figures 2A et 2B.

Les dimensions des creux 110 sont ici inférieures à la longueur d'onde d'émission des couches organiques 102 de manière à former une couche homogène vis-à-vis de la lumière émise par les couches organiques 102. Par exemple, les dimensions de la section des creux 110 (le diamètre sur l'exemple de la figure 2B et les côtés sur l'exemple de la figure 2A) peuvent être comprises entre environ 10 nm et 400 nm. La profondeur des creux réalisés est en rapport avec l'écart entre les indices de réfraction n₁ et n₂. Cette profondeur est par exemple comprise entre environ 10 nm et 100 nm. Par exemple, cette profondeur est proche d'environ 10 nm s'il existe une grande différence entre les indices n₁ et n₂. Cette profondeur est par contre de l'ordre d'une ou plusieurs centaines de nanomètres si la différence entre les indices de réfraction n₁ et n₂ est faible. Sur une même anode 104, les creux 110 sont par exemple répartis de manière régulière suivant une période inférieure à la longueur d'onde d'émission des couche organiques, c'est à dire comprise entre environ 30 nm et 400 nm. Cette période représente par exemple la distance séparant les centres de deux creux 110 se trouvant l'un à côté de l'autre.

Ainsi, en fonction des caractéristiques des motifs réalisés (dimensions, profondeurs, formes et espacements des creux 110), des indices de réfraction n₁ et n₂ des matériaux formant les anodes 104 et remplissant les creux 110 ainsi que du taux de réflexion de la cathode 106 et des anodes 104, il est possible de définir précisément la fréquence de résonance de chaque cavité optique 105 ainsi que la directivité de l'émission lumineuse réalisée.

Sur l'exemple de la figure 1A, les creux 110 réalisés dans l'anode 104a n'ont pas les mêmes dimensions que les creux 110 réalisés dans l'anode 104b. De plus, la période de répétition du motif des creux 110 de l'anode 104a est différente de celle de l'anode 104b. Il est également possible que les creux 110 aient des profondeurs différentes d'un pixel à l'autre. Pour cela, il n'est pas nécessaire de réaliser plusieurs niveaux de gravure car la vitesse de gravure peut être différente d'un pixel à l'autre en fonction des dimensions des motifs et donc, il est possible d'obtenir des creux de profondeurs différentes d'un pixel à l'autre avec un seul niveau de gravure. Donc, lorsque les couches organiques 102 émettent de la lumière, le filtrage réalisé dans la cavité optique 105a du dispositif 100 est différent de celui réalisé dans la cavité optique 105b. On obtient alors, au niveau de la cavité optique 105a, une émission lumineuse selon un longueur d'onde différente de l'émission lumineuse réalisée au niveau de la cavité optique 105b, ces deux pixels du dispositif 100 émettant donc une lumière de couleur différente.

Dans une variante de ce premier mode de réalisation, il est possible de ne pas remplir les creux 110 par le matériau 112, mais de déposer directement les couches organiques 102 sur les anodes 104 pour que le matériau des couches organiques 102 remplisse les creux 110. L'indice de réfraction n₂ désigne alors l'indice de réfraction du matériau organique des couches 102.

Sur la figure 1A, les deux anodes 104a, 104b sont isolées électriquement l'une de l'autre par une portion de matériau diélectrique 109, par exemple à base de silice, disposée sur le substrat 108.

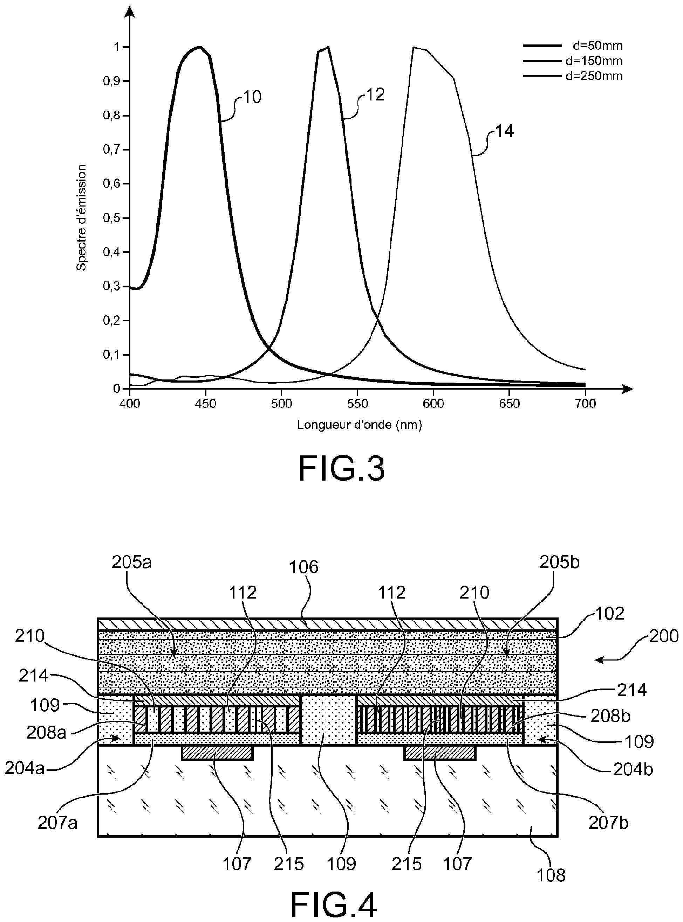

La figure 3 représente des simulations d'émission lumineuse de trois pixels du dispositif 100. Les anodes 104 de ces pixels comportent des creux 110 disposés selon un réseau de période constante et égale à environ 300 nm et de profondeur égale à environ 80 nm, remplis avec un matériau 112 d'indice de réfraction n₂ sensiblement similaire à l'indice de réfraction des couches organiques 102, par exemple 1,7. La cathode 106 a par exemple une épaisseur égale à environ 20 nm, l'ensemble des couches organiques 102 une épaisseur égale à environ 100 nm, et les anodes 104 une épaisseur égale à environ 300 nm. L'électroluminescence obtenue peut être modélisée par l'oscillation d'un dipôle électrique au milieu de chaque cavité optique. Ce dipôle est orienté suivant le plan des couches organiques 102 et son spectre d'émission, lorsqu'il n'est pas dans une cavité optique, est très large et quasiment homogène sur la plage de longueur d'onde d'environ 400 nm à 800 nm.

La courbe 10 représente le spectre d'émission obtenu en sortie du dispositif 100 par la cathode 106 pour des creux 110, de section carrée, dont la dimension d des côtés est égale à environ 50 nm. On voit que ce spectre d'émission est centré autour d'une longueur d'onde proche de 450 nm, c'est-à-dire de couleur bleu. La courbe 12 représente le spectre d'émission obtenu pour une dimension d des côtés de la section carrée des creux 110 égale à environ 150 nm. Ce spectre d'émission est centré autour d'une longueur d'onde proche d'environ 525 nm, c'est-à-dire de couleur verte. Enfin, la courbe 14 représente le spectre d'émission obtenu pour une dimension d des côtés de la section carrée des creux 110 égale à environ 250 nm. Ce spectre d'émission est centré autour d'une longueur d'onde proche d'environ 600 nm, c'est-à-dire de couleur rouge. Les coordonnées CIE (norme 1964) de ces courbes 10, 12 et 14 sont respectivement (0,16 ; 0,074), (0,27 ; 0,64) et (0,58 ; 0,39). On voit donc qu'en modifiant simplement les dimensions des creux, on obtient une émission lumineuse pouvant couvrir la gamme des longueurs d'ondes du spectre visible.

Le dispositif 100 peut être obtenu en réalisant la matrice d'anodes 104 par pulvérisation ou évaporation sur le substrat 108 comportant la matrice active de transistors 107. Les creux 110 sont ensuite réalisés par exemple par photolithogravure. Pour déposer le matériau 112 d'indice de réfraction n₂ dans les creux 110, des techniques de dépôt par centrifugation (ou « spin coating » en anglais) peuvent être mises en oeuvre si ce matériau 112 est à base de résine ou de PEDOT. Si ce matériau 112 est à base d'ITO, d'oxyde de silicium ou de nitrure de silicium, on peut mettre en oeuvre des techniques de dépôt CVD ou de pulvérisation. Après le dépôt du matériau 112, on peut ensuite réaliser une planarisation mécano-chimique afin d'obtenir une couche de matériau 112 ne dépassant pas des creux 110.

D'autres techniques peuvent être utilisées pour déposer le matériau 112 dans les creux 110.

On peut réaliser l'isolation électrique entre les anodes 104 par une gravure de tranchées entre les différents pixels, puis un dépôt de silice, par exemple par dépôt CVD, puis d'une étape de planarisation mécano-chimique afin de former la portion de silice 109 telle que celle-ci soit environ à la même hauteur que les anodes 104.

Les couches organiques électroluminescentes 102 peuvent être déposées par des techniques d'évaporation sous vide ou « spin coating ».

La cathode 106 est finalement déposée sur les couches organiques 102 par évaporation sous vide.

On se réfère maintenant à la figure 1B qui représente le dispositif émissif lumineux de type OLED 100 selon une variante du premier mode de réalisation.

Par rapport au dispositif représenté sur la figure 1A, le matériau 112 d'indice de réfraction n₂ forme ici une couche déposée dans les creux 110, mais également au-dessus des creux 110 et à côté des anodes 104a, 104b. Dans cette variante, le matériau 112 peut être transparent ou semi-transparent, et électriquement conducteur. Ainsi, lorsque les anodes 104a, 104b sont réalisées à base d'un matériau diélectrique, le matériau 112 assure la connexion électrique avec le circuit d'adressage formé par les transistors 107.

On se réfère maintenant à la figure 4 qui représente un dispositif émissif lumineux de type OLED 200 selon un seconde mode de réalisation.

Le dispositif 200 comporte le substrat 108 comprenant la matrice active de transistor 107, l'empilement de couches organiques électroluminescentes 102, le matériau de remplissage d'indice de réfraction n₂, la portion isolante 109 et la cathode 106 par exemple similaires aux éléments correspondants du dispositif 100 de la figure 1A. Le dispositif 200 comporte également une matrice d'anodes disposée sur le substrat 108. Deux anodes 204a et 204b sont représentées sur la figure 4. Contrairement aux anodes 104a, 104b de la figure 1A, les anodes 204a, 204b comportent chacune une couche, respectivement 207a et 207b, disposée sur le substrat 108, à base d'un matériau électriquement conducteur par exemple similaire au matériau des anodes 104 de la figure 1A.

Chaque anode 204 comporte également une couche 208a, 208b à base d'un matériau d'indice de réfraction n₁ disposée sur la couche conductrice 207a, 207b. Des motifs formant des creux 210 sont gravés dans les couches 208a, 208b, au niveau d'une face se trouvant du côté de cavités optiques 205a, 205b formées par les anodes 204a, 204b, les couches organiques 102 et la cathode 106. Dans ce second mode de réalisation, les creux 210 sont traversants, c'est à dire formés à travers toute l'épaisseur des couches 208a, 208b d'indice de réfraction n₁. Ces creux 210 sont remplis avec le matériau 112. L'indice de réfraction n₁ des couches gravées 208a, 208b est différent de l'indice de réfraction n₂ du matériau 112. Par rapport au premier mode de réalisation, la structure à double couches des anodes 204a, 204b permet de combiner le matériau de remplissage 112 d'indice de réfraction n₂ avec un choix plus vaste de matériaux, le matériau d'indice de réfraction n₁ pouvant être conducteur ou non, ainsi que de profiter de gravure sélective, facilitant le contrôle de gravure. Les couches 208a, 208b peuvent être à base de matériaux à changements de phase (présentant un comportement métallique à l'état cristallin et diélectrique à l'état amorphe), par exemple à base de matériaux chalcogénures, tel que de l'antimoniure d'indium. Les couches 208a, 208b peuvent également être à base d'un matériau isolant.

Une couche 214 électriquement conductrice et optiquement transparente ou partiellement transparente, par exemple à base d'ITO, est disposée entre les couches 208a, 208b et l'empilement de couches organiques électroluminescentes 102, sur les anodes 204a, 204b, entre les portions isolantes 109, homogénéisant la conduction électrique au niveau de chaque pixel. On voit sur la figure 4 que la portion de la couche 214 disposée sur l'anode 204a n'est pas en contact avec la portion de la couche 214 disposée sur l'anode 204b, afin d'isoler électriquement les pixel les uns des autres. Les couches 214 peuvent également être à base de TiN, et d'épaisseur comprise entre environ 2 nm et 20 nm.

Le matériau des couches 208a, 208b et/ou le matériau de remplissage 112 peut être électriquement conducteur, les anodes 204a, 204b étant alors reliées électriquement à la couche conductrice 214 par l'intermédiaire de ces matériaux. Toutefois, dans l'exemple représenté sur la figure 4, ces matériaux sont des matériaux diélectriques. Dans ce cas, le dispositif 200 comporte des portions de matériau électriquement conducteur 215 traversant les couches 208a, 208b d'indice de réfraction n₁ et/ou le matériau d'indice de réfraction n₂ 112, et reliant électriquement les couches conductrices inférieures 207a, 207b aux couches conductrices supérieures 214.

De plus, lorsque le dispositif ne comporte pas les couches conductrices 207a, 207b, et que le matériau des couches 208a, 208b, et éventuellement le matériau de remplissage 112, sont des diélectriques, ces portions de matériau conducteur peuvent relier électriquement les couches conductrices 214 au circuit d'adressage formé ici par les transistors 107.

Dans une variante des premier et second modes de réalisation, il est possible que l'électrode structurée d'une cavité optique ne soit pas disposée contre le substrat, mais soit disposée au-dessus des couches organiques électroluminescentes, c'est-à-dire du côté de l'électrode 106.

Dans une autre variante des premier et second modes de réalisation, les deux électrodes, anode et cathode, d'une cavité optique peuvent être structurées. Le paramétrage de la résonance des cavités optiques se fait alors au niveau des creux réalisés dans les deux électrodes.

Dans les modes de réalisation décrits précédemment, les électrodes 104a, 104b, 204a, 204b forment des anodes du dispositif émissif lumineux, et l'électrode 106 forme la cathode du dispositif. Toutefois, il est possible que les électrodes 104a, 104b, 204a, 204b forment des cathodes, l'électrode 106 formant alors l'anode du dispositif émissif lumineux.

Le dispositif émissif lumineux est particulièrement adapté pour la réalisation d'un micro-afficheur de type OLED. Il peut également être utilisé pour d'autres applications, par exemple pour la réalisation d'un imageur multicolore ou d'un spectrophotomètre.

L'invention s'applique à toute les technologies d'électroluminescence organique, telle que par exemple les dispositifs émissif lumineux de type PHOLED (« Phosphorescent OLED » en anglais) ou PLED (« Polymer Light Emitting Diode » en anglais).

Enfin, dans les dispositifs décrits précédemment, les couleurs d'émission des cavités optiques sont accordées uniquement par la structuration de la ou des électrodes. Il est possible en variante que le dispositif comporte des filtres colorés permettant d'affiner le spectre d'émission du dispositif, par exemple pour améliorer la pureté de la ou des couleurs émise et/ou supprimer des pics présents dans le spectre d'émission. Il est par exemple possible d'utiliser un filtre pleine plaque disposé sur le dispositif et commun à l'ensemble des pixels du dispositif.

## Revendications

1. Dispositif émissif lumineux de type OLED (100, 200) comportant au moins une cavité optique (105a, 105b, 205a, 205b) formant un pixel du dispositif émissif lumineux (100, 200) et comportant au moins une partie d'au moins une couche (102) à base d'un matériau organique électroluminescent disposée entre deux électrodes (104a, 104b, 204a, 204b, 106), **caractérisé en ce qu'**une des électrodes (104a, 104b, 204a, 204b, 106) est partiellement réfléchissante et l'autre est au moins partiellement réfléchissante, au moins une des deux électrodes (104a, 104b, 204a, 204b) comportant au moins une couche (104a, 104b, 208a, 208b) à base d'un matériau d'indice de réfraction n₁ dont une face structurée comprend une pluralité de creux (110, 210) remplis d'un matériau (102, 112) d'indice de réfraction n₂ différent de n₁, la lumière étant destinée à être émise du dispositif (100, 200) à travers l'une des électrodes (106) partiellement réfléchissante, et dans lequel les creux (110, 210) formés dans la couche (104a, 104b, 208a, 208b) de matériau d'indice de réfraction n₁ et le matériau (102, 112) d'indice de réfraction n₂ disposé dans les creux (110, 210) forment des moyens de filtrage en longueur d'onde de la lumière destinée à être émise du dispositif (100, 200), le motif des creux (110, 210) réalisés au niveau de la face structurée étant choisi en fonction du spectre d'émission souhaité de la cavité optique (105a, 105b, 205a, 205b).

2. Dispositif (100, 200) selon la revendication 1, les creux (110, 210) étant répartis régulièrement sur la face structurée et/ou de dimensions similaires.

3. Dispositif (100, 200) selon l'une des revendications précédentes, les creux (110, 210) ayant une profondeur dans la couche (104a, 104b, 208a, 208b) d'indice de réfraction n₁ comprise entre 10 nm et quelques centaines de nm.

4. Dispositif (100, 200) selon l'une des revendications précédentes, le matériau (104a, 104b, 208a, 208b) d'indice de réfraction n₁ et/ou le matériau (102, 112) d'indice de réfraction n₂ étant électriquement conducteurs.

5. Dispositif (200) selon l'une des revendications précédentes, comportant en outre au moins une couche inférieure (207a, 207b), à base d'au moins un matériau électriquement conducteur, tel un matériau métallique, sur laquelle est disposée la couche (208a, 208b) d'indice de réfraction n₁.

6. Dispositif (200) selon la revendication 5, comportant en outre au moins une portion de matériau électriquement conducteur (215) reliant la couche inférieure (207a, 207b) à la face structurée.

7. Dispositif (200) selon l'une des revendications précédentes, comportant en outre une couche supérieure (214) à base d'au moins un matériau électriquement conducteur et optiquement transparent ou partiellement transparent, tel que l'ITO, disposée sur la couche (208a, 208b) d'indice de réfraction n₁.

8. Dispositif (200) selon l'une des revendications précédentes, le matériau (208a, 208b) d'indice de réfraction n₁ et le matériau (112) d'indice de réfraction n₂ étant des diélectriques.

9. Dispositif (200) selon la revendication 8, comportant en outre, lorsque l'électrode (204a, 204b) comporte la couche inférieure (207a, 207b) et la couche supérieure (214), au moins une portion de matériau électriquement conducteur (215) reliant électriquement la couche inférieure (207a, 207b) à la couche supérieure (214).

10. Dispositif (100, 200) selon l'une des revendications précédentes, le matériau (102, 112) d'indice de réfraction n₂ et/ou le matériau d'indice de réfraction n₁ (104a, 104b, 208a, 208b) étant transparents ou partiellement transparents.

11. Dispositif (200) selon l'une des revendications précédentes, les creux (210) traversant la couche (208a, 208b) d'indice de réfraction n₁.

12. Dispositif (100) selon l'une des revendications précédentes, les creux (110) de la face structurée de l'électrode (104a, 104b) étant disposés du côté de la cavité optique (105a, 105b).

13. Dispositif (100) selon l'une des revendications précédentes, le matériau (102) d'indice de réfraction n₂ remplissant les creux (110) de la face structurée de l'électrode (104a, 104b) étant le matériau organique électroluminescent formant la couche (102) disposée entre les deux électrodes (104a, 104b, 106) .

14. Dispositif (100, 200) selon l'une des revendications 1 à 12, le matériau (112) d'indice de réfraction n₂ remplissant les creux (110, 210) de la face structurée de l'électrode (104a, 104b, 204a, 204b) étant un matériau distinct du matériau organique électroluminescent formant la couche (102) disposée entre les deux électrodes (104a, 104b, 204a, 204b, 106) .

15. Dispositif (100, 200) selon l'une des revendications précédentes, les creux (110, 210) de la face structurée étant régulièrement répartis selon un motif de répétition de période inférieure à la longueur d'onde d'émission du matériau organique électroluminescent (102).

16. Dispositif (100, 200) selon l'une des revendications précédentes, les dimensions des creux (110, 210) de la face structurée étant inférieures à la longueur d'onde d'émission du matériau organique électroluminescent (102).

17. Dispositif (100, 200) selon l'une des revendications précédentes, comportant en outre un substrat (108) contre lequel est disposée une des électrodes (104a, 104b, 204a, 204b) de la cavité optique (105a, 105b, 205a, 205b).

18. Dispositif (100, 200) selon la revendication 17, ladite électrode (104a, 104b, 204a, 204b) disposée contre le substrat (108) étant l'électrode comportant la couche (104a, 104b, 208a, 208b) à face structurée.

19. Dispositif (100, 200) selon l'une des revendications 17 ou 18, comportant une pluralité de cavités optiques (105a, 105b, 205a, 205b) comprenant chacune une électrode (104a, 104b, 204a, 204b) comportant au moins une couche (104a, 104b, 208a, 208b) à base d'un matériau d'indice de réfraction n₁ dont une face structurée comprend une pluralité de creux (110, 210) remplis d'un matériau (102, 112) d'indice de réfraction n₂ différent de n₁, formant une pluralité de pixels du dispositif émissif lumineux de type OLED (100, 200).

20. Dispositif (100, 200) selon la revendication 19, les creux (110, 210) de chaque électrode (104a, 104b, 204a, 204b) ayant des dimensions et/ou une période différentes d'un pixel à l'autre.

21. Dispositif (100, 200) selon l'une des revendications 19 ou 20, les électrodes (104a, 104b, 204a, 204b), comportant une couche (104a, 104b, 208a, 208b) à face structurée, des différents pixels étant électriquement isolées les unes des autres.

22. Dispositif (100, 200) selon l'une des revendications 19 à 21, les électrodes (106) de chaque cavité optique (105a, 105b, 205a, 205b) qui ne sont pas disposées contre le substrat (108) étant formées par une seule électrode commune à toutes les cavités optiques (105a, 105b, 205a, 205b).

23. Dispositif (100, 200) selon l'une des revendications 17 à 22, le substrat (108) comportant au moins un circuit d'adressage relié électriquement aux électrodes (104a, 104b, 204a, 204b) disposées contre le substrat (108) et pilotant les pixels du dispositif (100, 200).

24. Dispositif (100, 200) selon la revendication 23, le circuit d'adressage comportant une matrice de transistors (107), chacun des pixel étant piloté par un transistor (107) de cette matrice par l'intermédiaire des électrodes (104a, 104b, 204a, 204b) disposées contre le substrat (108).

25. Dispositif (100, 200) selon l'une des revendications 23 ou 24, comportant en outre, lorsque le matériau (104a, 104b, 208a, 208b) d'indice de réfraction n₁ et le matériau (102, 112) d'indice de réfraction n₂ sont des diélectriques, une portion de matériau conducteur (215) reliant électriquement le circuit d'adressage aux électrodes (104a, 104b, 204a, 204b) .

26. Procédé de réalisation d'un dispositif émissif lumineux de type OLED (100, 200), **caractérisé en ce qu'**il comporte au moins les étapes de :
a) dépôt d'une couche (104a, 104b, 208a, 208b) à base d'un matériau d'indice de réfraction n₁ sur un substrat (108),
b) gravure d'une pluralité de creux (110, 210) à travers au moins une face de la couche (104a, 104b, 208a, 208b),
c) dépôt d'un matériau (102, 112) d'indice de réfraction n₂, différent de n₁, dans les creux,
le dispositif (100, 200) comportant au moins une cavité optique (105a, 105b, 205a, 205b) formant un pixel du dispositif émissif lumineux (100, 200) et comportant au moins une partie d'au moins une couche (102) à base d'un matériau organique électroluminescent disposée entre deux électrodes (104a, 104b, 204a, 204b, 106) dont l'une est partiellement réfléchissante et l'autre est au moins partiellement réfléchissante, au moins l'une des deux électrodes (104a, 104b, 204a, 204b) comportant la couche (104a, 104b, 208a, 208b) à base du matériau d'indice de réfraction n₁, la lumière étant destinée à être émise du dispositif (100, 200) à travers l'une des électrodes (106) partiellement réfléchissante, et dans lequel les creux (110, 210) formés dans la couche (104a, 104b, 208a, 208b) de matériau d'indice de réfraction n₁ et le matériau (102, 112) d'indice de réfraction n₂ disposé dans les creux (110, 210) forment des moyens de filtrage en longueur d'onde de la lumière destinée à être émise du dispositif (100, 200), le motif des creux (110, 210) réalisés au niveau de la face structurée étant choisi en fonction du spectre d'émission souhaité de la cavité optique (105a, 105b, 205a, 205b).

27. Procédé selon la revendication 26, comportant en outre, avant l'étape a), une étape de dépôt d'une couche inférieure (207a, 207b) à base d'au moins un matériau électriquement conducteur, la couche (208a, 208b) à base du matériau d'indice de réfraction n₁ n'étant pas, à l'étape a), déposée directement sur le substrat (108) mais sur la couche inférieure (207a, 207b) .

28. Procédé selon la revendication 27, comportant en outre, après l'étape c), une étape de réalisation d'une portion de matériau électriquement conducteur (215) reliant la couche inférieure (207a, 207b) à la face comportant la pluralité de creux (210).

29. Procédé selon l'une des revendications 26 à 28, comportant en outre, après l'étape c), une étape de dépôt d'une couche supérieure (214) à base d'un matériau électriquement conducteur sur la couche (208a, 208b) de matériau d'indice de réfraction n₁.

30. Procédé selon l'une des revendications 26 à 29, l'étape c) étant une étape de dépôt d'au moins une couche organique électroluminescente (102) sur la face de la couche (104a, 104b) de matériau d'indice de réfraction n₁ comportant les creux (110), cette couche organique électroluminescente (102) étant à base du matériau d'indice de réfraction n₂.

31. Procédé selon l'une des revendications 26 à 29, comportant, après l'étape c), une étape de dépôt d'au moins une couche organique électroluminescente (102) sur la couche (104a, 104b, 208a, 208b) de matériau d'indice de réfraction n₁.

32. Procédé selon la revendication 31, comportant, après l'étape de dépôt de la couche organique électroluminescente (102), une étape de réalisation d'une couche (214) à base d'un matériau électriquement conducteur et au moins semi-transparent sur la couche organique électroluminescente (102).

## Patentansprüche

1. Lichtemittierende Vorrichtung vom OLED-Typ (100, 200), welche wenigstens eine optische Kavität (105a, 105b, 205a, 205b) umfasst, welche einen Pixel der lichtemittierenden Vorrichtung (100, 200) bildet und wenigstens einen Abschnitt wenigstens einer Schicht (102) auf Grundlage eines elektrolumineszenten organischen Materials umfasst, welche zwischen zwei Elektroden (104a, 104b, 204a, 204b, 106) angeordnet ist, **dadurch gekennzeichnet, dass** eine der Elektroden (104a, 104b, 204a, 204b, 106) teilweise reflektierend ist und die andere wenigstens teilweise reflektierend ist, wobei wenigstens eine der beiden Elektroden (104a, 104b, 204a, 204b) wenigstens eine Schicht (104a, 104b, 208a, 208b) auf Grundlage eines Materials vom Brechungsindex n₁ umfasst, von welcher eine strukturierte Fläche eine Mehrzahl von Aushöhlungen (110, 210) umfasst, welche mit einem Material (102, 112) vom Brechungsindex n₂ aufgefüllt sind, welcher von n₁ verschieden ist, wobei das Licht dazu vorgesehen ist, von der Vorrichtung (100, 200) durch eine der teilweise reflektierenden Elektroden (106) hindurch emittiert zu werden, und wobei die Aushöhlungen (110, 210), welche in der Schicht (104a, 104b, 208a, 208b) aus Material vom Brechungsindex n₁ gebildet sind, und das Material (102, 112) vom Brechungsindex n₂, welches in den Aushöhlungen (110, 210) angeordnet ist, Filtermittel für die Wellenlänge des Lichts bilden, welches dazu vorgesehen ist, von der Vorrichtung (100, 200) emittiert zu werden, wobei das Muster der Aushöhlungen (110, 210), welche auf dem Niveau der strukturierten Fläche gebildet sind, als Funktion des gewünschten Emissionsspektrums der optischen Kavität (105a, 105b, 205a, 205b) ausgewählt ist.

2. Vorrichtung (100, 200) nach Anspruch 1, wobei die Aushöhlungen (110, 210) gleichmäßig auf der strukturierten Fläche verteilt sind und/oder von ähnlichen Abmessungen sind.

3. Vorrichtung (100, 200) nach einem der vorhergehenden Ansprüche, wobei die Aushöhlungen (110, 210) eine Tiefe in der Schicht (104a, 104b, 208a, 208b) vom Brechungsindex n₁ aufweisen, welche zwischen 10 nm und einigen hundert nm beträgt.

4. Vorrichtung (100, 200) nach einem der vorhergehenden Ansprüche, wobei das Material (104a, 104b, 208a, 208b) vom Brechungsindex n₁ und/oder das Material (102, 112) vom Brechungsindex n₂ elektrisch leitfähig sind.

5. Vorrichtung (200) nach einem der vorhergehenden Ansprüche, ferner umfassend wenigstens eine untere Schicht (207a, 207b) auf Grundlage wenigstens eines elektrisch leitfähigen Materials, beispielsweise eines metallischen Materials, auf welcher die Schicht (208a, 208b) vom Brechungsindex n₁ angeordnet ist.

6. Vorrichtung (200) nach Anspruch 5, ferner umfassend wenigstens einen Abschnitt aus elektrisch leitfähigem Material (215), welcher die untere Schicht (207a, 207b) mit der strukturierten Fläche verbindet.

7. Vorrichtung (200) nach einem der vorhergehenden Ansprüche, ferner umfassend eine obere Schicht (214) auf Grundlage wenigstens eines elektrisch leitfähigen und optisch transparenten oder teilweise transparenten Materials, wie beispielsweise ITO, welche auf der Schicht (208a, 208b) vom Brechungsindex n₁ angeordnet ist.

8. Vorrichtung (200) nach einem der vorhergehenden Ansprüche, wobei das Material (208a, 208b) vom Brechungsindex n₁ und das Material (112) vom Brechungsindex n₂ Dielektrika sind.

9. Vorrichtung (200) nach Anspruch 8, ferner umfassend, wenn die Elektrode (204a, 204b) die untere Schicht (207a, 207b) und die obere Schicht (214) umfasst, wenigstens einen Abschnitt aus elektrisch leitfähigem Material (215), welcher die untere Schicht (207a, 207b) mit der oberen Schicht (214) verbindet.

10. Vorrichtung (100, 200) nach einem der vorhergehenden Ansprüche, wobei das Material (102, 112) vom Brechungsindex n₂ und/oder das Material vom Brechungsindex n₁ (104a, 104b, 208a, 208b) transparent oder teilweise transparent sind.

11. Vorrichtung (200) nach einem der vorhergehenden Ansprüche, wobei die Aushöhlungen (210) durch die Schicht (208a, 208b) vom Brechungsindex n₁ hindurchtreten.

12. Vorrichtung (100) nach einem der vorhergehenden Ansprüche, wobei die Aushöhlungen (110) der strukturierten Fläche der Elektrode (104a, 104b) auf der Seite der optischen Kavität (105a, 105b) angeordnet sind.

13. Vorrichtung (100) nach einem der vorhergehenden Ansprüche, wobei das Material (102) vom Brechungsindex n₂, welches die Aushöhlungen (110) der strukturierten Fläche der Elektrode (104a, 104b) auffüllt, das elektrolumineszente organische Material ist, welches die Schicht (102) bildet, welche zwischen den beiden Elektroden (104a, 104b, 106) angeordnet ist.

14. Vorrichtung (100, 200) nach einem der Ansprüche 1 bis 12, wobei das Material (112) vom Brechungsindex n₂, welches die Aushöhlungen (110, 210) der strukturierten Fläche der Elektrode (104a, 104b, 204a, 204b) auffüllt, ein Material ist, welches verschieden von dem elektrolumineszenten organischen Material ist, welches die Schicht (102) bildet, welche zwischen den beiden Elektroden (104a, 104b, 204a, 204b, 106) angeordnet ist.

15. Vorrichtung (100, 200) nach einem der vorhergehenden Ansprüche, wobei die Aushöhlungen (110, 210) der strukturierten Fläche gleichmäßig entlang eines Musters einer Wiederholung mit kleinerer Periode als die Emissionswellenlänge des elektrolumineszenten organischen Materials (102) beabstandet sind.

16. Vorrichtung (100, 200) nach einem der vorhergehenden Ansprüche, wobei die Abmessungen der Aushöhlungen (110, 210) der strukturierten Fläche kleiner als die Emissionswellenlänge des elektrolumineszenten organischen Materials (102) sind.

17. Vorrichtung (100, 200) nach einem der vorhergehenden Ansprüche, ferner umfassend ein Substrat (108), gegen welches eine der Elektroden (104a, 104b, 204a, 204b) der optischen Kavität (105a, 105b, 205a, 205b) angeordnet ist.

18. Vorrichtung (100, 200) nach Anspruch 17, wobei die Elektrode (104a, 104b, 204a, 204b), welche gegen das Substrat (108) angeordnet ist, die Elektrode ist, welche die Schicht (104a, 104b, 208a, 208b) mit strukturierter Fläche umfasst.

19. Vorrichtung (100, 200) nach einem der Ansprüche 17 oder 18, umfassend eine Mehrzahl von optischen Kavitäten (105a, 105b, 205a, 205b), jede umfassend eine Elektrode (104a, 104b, 204a, 204b), umfassend wenigstens eine Schicht (104a, 104b, 208a, 208b) auf Grundlage eines Materials vom Brechungsindex n₁, von welcher eine strukturierte Fläche eine Mehrzahl von Aushöhlungen (110, 210) umfasst, welche mit einem Material (102, 112) vom Brechungsindex n₂ gefüllt sind, welcher von n₁ verschieden ist, wobei eine Mehrzahl von Pixeln der lichtemittierenden Vorrichtung vom OLED-Typ (100, 200) gebildet sind.

20. Vorrichtung (100, 200) nach Anspruch 19, wobei die Aushöhlungen (110, 210) von jeder Elektrode (104a, 104b, 204a, 204b) Abmessungen und/oder eine Periode aufweisen, welche von einem Pixel zu dem anderen unterschiedlich sind.

21. Vorrichtung (100, 200) nach einem der Ansprüche 19 oder 20, wobei die Elektroden (104a, 104b, 204a, 204b), welche eine Schicht (104a, 104b, 208a, 208b) mit strukturierter Fläche umfassen, von unterschiedlichen Pixeln elektrisch voneinander isoliert sind.

22. Vorrichtung (100, 200) nach einem der Ansprüche 19 bis 21, wobei die Elektroden (106) von jeder optischen Kavität (105a, 105b, 205a, 205b), welche nicht gegen das Substrat (108) angeordnet sind, durch eine einzelne Elektrode gebildet sind, welche allen der optischen Kavitäten (105a, 105b, 205a, 205b) gemeinsam ist.

23. Vorrichtung (100, 200) nach einem der Ansprüche 17 bis 22, wobei das Substrat (108) wenigstens eine Adressierungsschaltung umfasst, welche mit den Elektroden (104a, 104b, 204a, 204b) elektrisch verbunden ist, welche gegen das Substrat (108) angeordnet sind, und die Pixel der Vorrichtung (100, 200) ansteuert.

24. Vorrichtung (100, 200) nach Anspruch 23, wobei die Adressierungsschaltung eine Matrix von Transistoren (107) umfasst, wobei jeder der Pixel durch einen Transistor (107) aus dieser Matrix mittels der Elektroden (104a, 104b, 204a, 204b) angesteuert wird, welche gegen das Substrat (108) angeordnet sind.

25. Vorrichtung (100, 200) nach einem der Ansprüche 23 oder 24, ferner umfassend, wenn das Material (104a, 104b, 208a, 208b) vom Brechungsindex n₁ und das Material (102, 112) vom Brechungsindex n₂ Dielektrika sind, einen Abschnitt aus leitfähigem Material (215), welcher die Adressierungsschaltung mit den Elektroden (104a, 104b, 204a, 204b) elektrisch verbindet.

26. Verfahren zum Herstellen einer lichtemittierenden Vorrichtung vom OLED-Typ (100, 200), **dadurch gekennzeichnet, dass** es wenigstens die Schritte umfasst:
a) Anlagern einer Schicht (104a, 104b, 208a, 208b) auf Grundlage eines Materials vom Brechungsindex n₁ auf einem Substrat (108),
b) Abtragen einer Mehrzahl von Aushöhlungen (110, 210) durch wenigstens eine Fläche der Schicht (104a, 104b, 208a, 208b) hindurch,
c) Anlagern eines Materials (102, 112) vom Brechungsindex n₂, welcher verschieden von n₁ ist, in den Aushöhlungen,
wobei die Vorrichtung (100, 200) wenigstens eine optische Kavität (105a, 105b, 205a, 205b) umfasst, welche einen Pixel der lichtemittierenden Vorrichtung (100, 200) bildet, und umfassend wenigstens einen Abschnitt wenigstens einer Schicht (102) auf Grundlage eines elektrolumineszenten organischen Materials, welche zwischen zwei Elektroden (104a, 104b, 204a, 204b, 106) angeordnet ist, von welchen eine teilweise reflektierend ist und die andere wenigstens teilweise reflektierend ist, wobei wenigstens eine der beiden Elektroden (104a, 104b, 204a, 204b) die Schicht (104a, 104b, 208a, 208b) auf Grundlage des Materials vom Brechungsindex n₁ umfasst, wobei das Licht dazu vorgesehen ist, von der Vorrichtung (100, 200) durch die eine der teilweise reflektierenden Elektroden (106) hindurch emittiert zu werden, und wobei die Aushöhlungen (110, 210), welche in der Schicht (104a, 104b, 208a, 208b) aus Material vom Brechungsindex n₁ gebildet sind, und das Material (102, 112) vom Brechungsindex n₂, welches in den Aushöhlungen (110, 210) angeordnet ist, Filtermittel für die Wellenlänge des Lichts bilden, welches dazu vorgesehen ist, von der Vorrichtung (100, 200) emittiert zu werden, wobei das Muster der Aushöhlungen (110, 210), welche auf dem Niveau der strukturierten Fläche gebildet sind, als Funktion des gewünschten Emissionsspektrums der optischen Kavität (105a, 105b, 205a, 205b) ausgewählt ist.

27. Verfahren nach Anspruch 26, ferner umfassend vor dem Schritt a) einen Schritt eines Anlagerns einer unteren Schicht (207a, 207b) auf Grundlage von wenigstens einem elektrisch leitfähigen Material, wobei die Schicht (208a, 208b) auf Grundlage des Materials vom Brechungsindex n₁ in dem Schritt a) nicht direkt auf dem Substrat (108), sondern auf der unteren Schicht (207a, 207b) angelagert wird.

28. Verfahren nach Anspruch 27, ferner umfassend nach dem Schritt c) einen Schritt eines Herstellens von einem Abschnitt aus elektrisch leitfähigem Material (215), welcher die untere Schicht (207a, 207b) mit der Fläche verbindet, welche die Mehrzahl von Aushöhlungen (210) umfasst.

29. Verfahren nach einem der Ansprüche 26 bis 28, ferner umfassend nach dem Schritt c) einen Schritt eines Anlagerns einer oberen Schicht (214) auf Grundlage eines elektrisch leitfähigen Materials auf der Schicht (208a, 208b) aus Material vom Brechungsindex n₁.

30. Verfahren nach einem der Ansprüche 26 bis 29, wobei der Schritt c) ein Schritt eines Anlagerns von wenigstens einer elektrolumineszenten organischen Schicht (102) auf der Fläche der Schicht (104a, 104b) aus Material vom Brechungsindex n₁ ist, welche die Aushöhlungen (110) umfasst, wobei die elektrolumineszente organische Schicht (102) auf Grundlage des Materials vom Brechungsindex n₂ ist.

31. Verfahren nach einem der Ansprüche 26 bis 29, umfassend nach dem Schritt c) einen Schritt eines Anlagerns von wenigstens einer elektrolumineszenten organischen Schicht (102) auf der Schicht (104a, 104b, 208a, 208b) aus Material vom Brechungsindex n₁.

32. Verfahren nach Anspruch 31, umfassend nach dem Schritt des Anlagerns der elektrolumineszenten organischen Schicht (102) einen Schritt eines Herstellens einer Schicht (214) auf Grundlage eines elektrisch leitfähigen und wenigstens halb-transparenten Materials auf der elektrolumineszenten organischen Schicht (102).

## Claims

1. A light-emitting device of the OLED type (100, 200) including at least one optical cavity (105a, 105b, 205a, 205b) forming a pixel of the light-emitting device (100, 200) and including at least one portion of at least one layer (102) comprising an electroluminescent organic material arranged between two electrodes (104a, 104b, 204a, 204b, 106), **characterized in that** one of the electrodes (104a, 104b, 204a, 204b, 106) is partly reflective and the other one is at least partly reflective, at least one of the two electrodes (104a, 104b, 204a, 204b) including at least one layer (104a, 104b, 208a, 208b) comprising a material of refractive index n₁ including a structured face comprising a plurality of recesses (110, 210) filled with a material (102, 112) of refractive index n₂ different from n₁, the light being intended to be emitted from the device (100, 200) through one of the electrodes (106) partly reflective, and in which the recesses (110, 210) formed in the layer (104a, 104b, 208a, 208b) of material of refractive index n₁ and the material (102, 112) of refractive index n₂ arranged in the recesses (110, 210) form wavelength filtering means of the light intended to be emitted from the device (100, 200), the pattern of the recesses (110, 210) made at the structured face being chosen according to the desired emission spectrum of the optical cavity (105a, 105b, 205a, 205b).

2. The device (100, 200) according to claim 1, the recesses (110, 210) being regularly distributed on the structured face and/or of similar dimensions.

3. The device (100, 200) according to any of the preceding claims, the recesses (110, 210) having a depth in the layer (104a, 104b, 208a, 208b) of refractive index n₁ comprised between 10 nm and a few hundred nm.

4. The device (100, 200) according to any of the preceding claims, the material (104a, 104b, 208a, 208b) of refractive index n₁ and/or the material (102, 112) of refractive index n₂ being electrically conducting.

5. The device (200) according to any of the preceding claims, further including at least one lower layer (207a, 207b), comprising at least one electrically conducting material, such as a metal material, on which the layer (208a, 208b) of refractive index n₁ is arranged.

6. The device (200) according to claim 5, further including at least one portion of an electrically conducting material (215) connecting the lower layer (207a, 207b) to the structured face.

7. The device (200) according to any of the preceding claims, further including an upper layer (214) comprising at least one electrically conducting and optically transparent or partly transparent material, such as ITO, arranged on the layer (208a, 208b) of refractive index n₁.

8. The device (200) according to any of the preceding claims, the material (208a, 208b) of refractive index n₁ and the material (112) of refractive index n₂ being dielectrics.

9. The device (200) according to claim 8, further including, when the electrode (204a, 204b) includes the lower layer (207a, 207b) and the upper layer (214), at least one portion of electrically conducting material (215) electrically connecting the lower layer (207a, 207b) to the upper layer (214).

10. The device (100, 200) according to any of the preceding claims, the material (102, 112) of refractive index n₂ and/or the material of refractive index n₁ (104a, 104b, 208a, 208b) being transparent or partly transparent.

11. The device (200) according to any of the preceding claims, the recesses (210) passing through the layer (208a, 208b) of refractive index n₁.

12. The device (100) according to any of the preceding claims, the recesses (110) of the structured face of the electrode (104a, 104b) being arranged on the side of the optical cavity (105a, 105b).

13. The device (100) according to any of the preceding claims, the material (102) of refractive index n₂ filling the recesses (110) of the structured face of the electrode (104a, 104b) being the electroluminescent organic material forming the layer (102) arranged between both electrodes (104a, 104b, 106).

14. The device (100, 200) according to any of claims 1 to 12, the material (112) of refractive index n₂ filling the recesses (110, 210) of the structured face of the electrode (104a, 104b, 204a, 204b) being a material distinct from the electroluminescent organic material forming the layer (102) arranged between both electrodes (104a, 104b, 204a, 204b, 106).

15. The device (100, 200) according to any of the preceding claims, the recesses (110, 210) of the structured face being regularly distributed according to a recurrent pattern with a period smaller than the emission wavelength of the electroluminescent organic material (102).

16. The device (100, 200) according to any of the preceding claims, the dimensions of the recesses (110, 210) of the structured face being smaller than the emission wavelength of the electroluminescent organic material (102).

17. The device (100, 200) according to any of the preceding claims, further including a substrate (108) against which is arranged one of the electrodes (104a, 104b, 204a, 204b) of the optical cavity (105a, 105b, 205a, 205b).

18. The device (100, 200) according to claim 17, said electrode (104a, 104b, 204a, 204b) arranged against the substrate (108) being the electrode including the layer (104a, 104b, 208a, 208b) with a structured face.

19. The device (100, 200) according to any of claims 17 or 18, including a plurality of optical cavities (105a, 105b, 205a, 205b) each comprising an electrode (104a, 104b, 204a, 204b) including at least one layer (104a, 104b, 208a, 208b) comprising a material of refractive index n₁ including a structured face comprising a plurality of recesses (110, 210) filled with a material (102, 112) of refractive index n₂ different from n₁, forming a plurality of pixels of the light-emitting device of the OLED type (100, 200).

20. The device (100, 200) according to claim 19, the recesses (110, 210) of each electrode (104a, 104b, 204a, 204b) having different dimensions and/or period from one pixel to the other.

21. The device (100, 200) according to any of claims 19 or 20, the electrodes (104a, 104b, 204a, 204b), including a layer (104a, 104b, 208a, 208b) with a structured face, of different pixels being electrically insulated from each other.

22. The device (100, 200) according to any of claims 19 to 21, the electrodes (106) of each optical cavity (105a, 105b, 205a, 205b) which are not arranged against the substrate (108) being formed by a single electrode common to all the optical cavities (105a, 105b, 205a, 205b).

23. The device (100, 200) according to any of claims 17 to 22, the substrate (108) including at least one addressing circuit electrically connected to the electrodes (104a, 104b, 204a, 204b) arranged against the substrate (108) and driving the pixels of the device (100, 200).

24. The device (100, 200) according to claim 23, the addressing circuit including a matrix of transistors (107), each of the pixels being driven by a transistor (107) of this matrix via electrodes (104a, 104b, 204a, 204b) arranged against the substrate (108).

25. The device (100, 200) according to any of claims 23 or 24, further including, when the material (104a, 104b, 208a, 208b) of refractive index n₁ and the material (102, 112) of refractive index n₂ are dielectrics, a portion of conducting material (215) electrically connecting the addressing circuit to the electrodes (104a, 104b, 204a, 204b).

26. A method for making a light-emitting device of the OLED type (100, 200), including at least the steps of:
a) depositing a layer (104a, 104b, 208a, 208b) comprising a material of refractive index n₁ on a substrate (108),
b) etching a plurality of recesses (110, 210) through at least one face of the layer (104a, 104b, 208a, 208b),
c) depositing a material (102, 112) of refractive index n₂, different from n₁, in the recesses,
the device (100, 200) including at least one optical cavity (105a, 105b, 205a, 205b) forming a pixel of the light-emitting device (100, 200) and including at least one portion of at least one layer (102) comprising an electroluminescent organic material arranged between both electrodes (104a, 104b, 204a, 204b, 106), one of which is partly reflective and the other one is at least partly reflective, at least one of the two electrodes (104a, 104b, 204a, 204b) including the layer (104a, 104b, 208a, 208b) comprising the material of refractive index n₁, the light being intended to be emitted from the device (100, 200) through one of the partly reflective electrodes (106), and in which the recesses (110, 210) formed in the layer (104a, 104b, 208a, 208b) of material of refractive index n₁ and the material (102, 112) of refractive index n₂ arranged in the recesses (110, 210) form wavelength filtering means of the light intended to be emitted from the device (100, 200), the pattern of the recesses (110, 210) made at the structured face being chosen according to the desired emission spectrum of the optical cavity (105a, 105b, 205a, 205b).

27. The method according to claim 26, further including before step a), a step for depositing a lower layer (207a, 207b) comprising at least one electrically conducting material, the layer (208a, 208b) comprising the material of refractive index n₁ in step a) not being directly deposited on the substrate (108) but on the lower layer (207a, 207b).

28. The method according to claim 27, further including after step c), a step for producing a portion of electrically conducting material (215), connecting the lower layer (207a, 207b) to the face including the plurality of recesses (210).

29. The method according to any of claims 26 to 28, further including after step c), a step for depositing an upper layer (214) comprising an electrically conducting material on the layer (208a, 208b) of material of refractive index n₁.

30. The method according to any of claims 26 to 29, step c) being a step for depositing at least one electroluminescent organic layer (102) on the face of the layer (104a, 104b) of material of refractive index n₁ including the recesses (110), this electroluminescent organic layer (102) comprising the material of refractive index n₂.

31. The method according to any of claims 26 to 29, including after step c), a step for depositing at least one electroluminescent organic layer (102) on the layer (104a, 104b, 208a, 208b) of material of refractive index n₁.

32. The method according to claim 31, including after the step for depositing the electroluminescent organic layer (102), a step for producing a layer (214) comprising an electrically conducting and at least semi-transparent material on the electroluminescent organic layer (102).
